(19) Europäisches Patentamt
European Patent Office
Office européen des brevets

(11) **EP 2 144 099 A1**

(12) **DEMANDE DE BREVET EUROPEEN**

(43) Date de publication:
**13.01.2010 Bulletin 2010/02**

(51) Int Cl.:
***G02B 6/122*** *(2006.01)* ***H01S 5/18*** *(2006.01)*

(21) Numéro de dépôt: **09164818.8**

(22) Date de dépôt: **07.07.2009**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **11.07.2008 FR 0803984**

(71) Demandeur: **Thales**
**92200 Neuilly-sur-Seine (FR)**

(72) Inventeurs:
• **De Rossi, Alfredo**
**PARIS, 75014 (FR)**

• **Combrie, Sylvain**
**75014, PARIS (FR)**
• **Tran, Nguyen Vy Quynh**
**tinh Dong Nai, (VN)**

(74) Mandataire: **Esselin, Sophie et al**
**Marks & Clerk France**
**Conseils en Propriété Industrielle**
**Immeuble " Visium "**
**22, avenue Aristide Briand**
**94117 Arcueil Cedex (FR)**

(54) **Extracteur de photons a cristaux photoniques pour micro-sources optiques a fort rendement**

(57) L'invention concerne un extracteur de photons comportant une membrane à base de cristal photonique présentant un plan défini par deux directions perpendiculaires comprenant un ensemble de motifs et une cavité sans motifs depuis laquelle peuvent être extraits des photons caractérisée en ce que la membrane comporte au moins une région à proximité de la cavité, ladite région comportant des motifs répartis selon une double périodicité ($a_1, 2a_1, a_2, 2a_2$) selon au moins une direction, permettant un diagramme de rayonnement présentant une forte directivité et une surface d'émission homogène.

FIG.17b

EP 2 144 099 A1

**Description**

Le domaine de l'invention est celui des dispositifs optiques à micro-cavité et notamment celui des sources laser à micro-cavité qui présentent des propriétés spécifiques en terme d'émission de photons, de très petite taille et de très faible consommation, particulièrement recherchés pour des applications dans le domaine des communications quantiques (cryptographie, calcul,..) ou pour l'intégration dite « extrême » (correspondant à environ un millier de sources laser avec consommation de l'ordre du microWatt).

Une autre application de l'invention concerne le couplage entrée/sortie des microstructures sur membrane avec l'extérieur (fibre optique, interconnexion).

Il est déjà connu des dispositifs optiques pouvant être de très petites dimensions élaborés à partir de cristaux photoniques et comportant une cavité dont peut être extraite de la lumière.

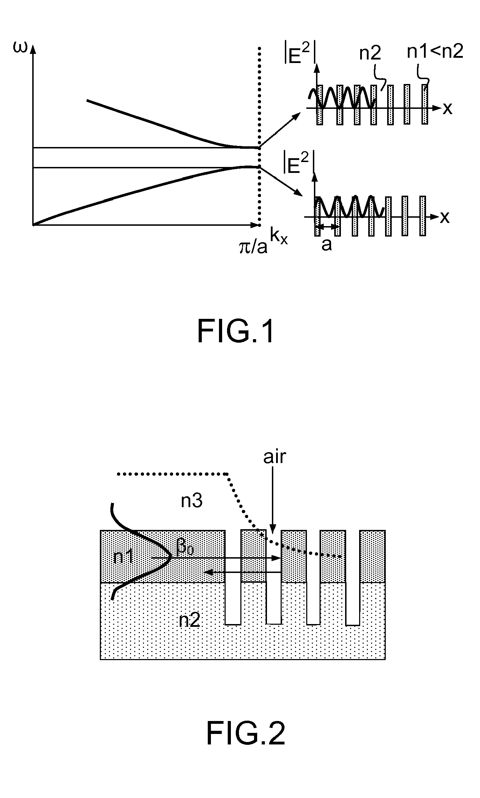

De manière générale, les cristaux photoniques sont des structures dont l'indice diélectrique varie de manière périodique à l'échelle de la longueur d'onde, sur une ou plusieurs directions de l'espace. La figure 1 illustre l'intensité du champ électrique d'une onde électromagnétique se propageant dans ce type de structure et montre le diagramme de dispersion d'une structure de période a dans la première zone de Brillouin ; le vecteur d'onde k est compris dans l'intervalle $0 < k < \pi / a$. On sait structurer artificiellement des matériaux par exemple semiconducteurs pour mettre à profit les effets de diffraction permettant par la même d'élaborer des fonctions optiques passives et actives nécessaires par exemple aux réseaux de télécommunications sur fibre optique.

Par ailleurs un des attraits majeurs de ces structures repose sur l'insertion contrôlée de défauts au sein du cristal. Ces défauts peuvent générer des états aux fréquences de bande interdite du cristal et ainsi permettre un champ électromagnétique propagatif pour ces fréquences. Un contrôle de la propagation de la lumière au sein du cristal et à l'échelle de la longueur d'onde est alors envisageable via ces défauts. L'utilisation de ces structures ouvre ainsi la voie à la miniaturisation des composants en optique intégrée.

Par rapport aux structures cristallines en trois dimensions, il a été montré qu'une structure en deux dimensions pouvait être particulièrement intéressante. On réalise dans ce cas des cristaux dans une fine couche guidante semiconductrice ce qui permet un meilleur contrôle et une technologie plus aisée de réalisation compatible des technologies classiques de microélectronique.

On isole une couche très fine constituant ainsi une membrane pouvant typiquement présenter une épaisseur h de l'ordre de 150 nanomètres à 300 nanomètres pour les applications visant le domaine spectral entre environ 1 micron et 1.6 microns. Par une simple loi, cette épaisseur est ajustée pour étendre l'application à d'autres domaines spectraux. La loi est la suivante :

h est compris entre 0.1 et 0.3 fois la longueur d'onde.

Le matériau utilisé peut typiquement être du silicium ou un matériau semiconducteur à base d'éléments des colonnes III et V de la table périodique de Mendeleyev (semiconducteurs « III-V », par exemple GaAs, AlGaAs, GaInP, InP, AlGaAsP,...). D'autres matériaux aussi envisageables sont les semiconducteurs de la famille II-VI (par exemple le ZnO) ainsi que le SiN. On crée au sein de ces membranes, un guide d'onde avec une forte variation d'indice optique comme illustré en figure 2. On peut notamment régler la vitesse de propagation des ondes et la dispersion des modes guidés en faisant varier la taille des motifs.

En créant une rupture au niveau d'une telle structure périodique par exemple par omission de certains trous, il devient possible de créer une cavité photonique au sein de laquelle l'énergie reste stockée. Une telle cavité peut alors assurer une fonction de filtre avec des modes en résonnance ou bien constituer une cavité laser émettant dans un plan perpendiculaire au plan de la membrane.

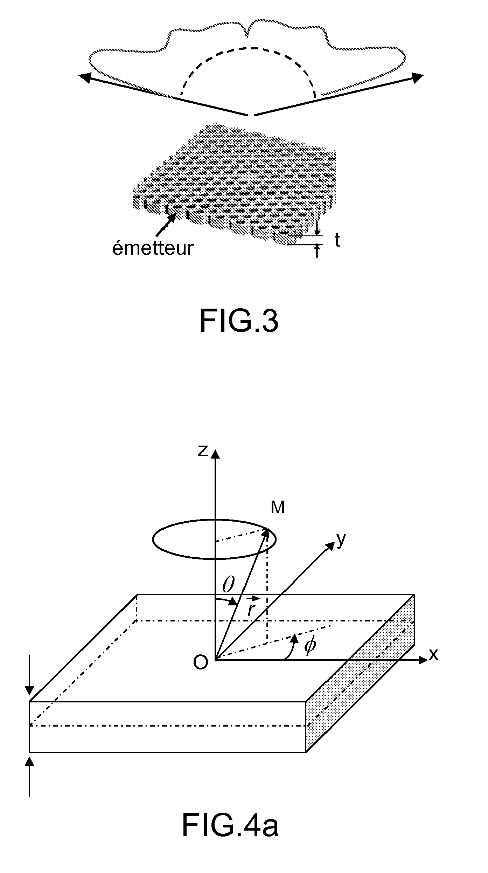

Néanmoins selon l'art existant, le faisceau de lumière issu de ce type de structure reste fortement divergent comme illustré en figure 3 et nécessite une optique de collection très puissante pour récupérer l'énergie. Par ailleurs, le diagramme de rayonnement du faisceau optique récupéré est également peu homogène.

Il a déjà été proposé par un groupe à l'institut de technologie de Koree (KAIST), une optimisation empirique d'un type de cavité « hexapole » décrite notamment dans l'article de Se-Heon Kim, Sun-Kyung Kim, and Yong-Hee Lee, Vertical beaming of wavelength-scale photonic crystal resonators, PHYSICAL REVIEW B 73, 235117 (2006)). Elle consiste à générer des défauts ponctuels pour rompre la périodicité des motifs. Cette optimisation est cependant très sensible aux imperfections de fabrication et en pratique, les tolérances requises pour obtenir un diagramme d'émission bien défini ne sont pas atteignables par la technologie de fabrication actuelle.

Pour résoudre ces différents problèmes, et notamment l'extraction de la lumière de manière satisfaisante en sortie du cristal photonique, la présente invention propose une structure optimisée permettant d'extraire de la lumière d'un cristal photonique et ce avec un diagramme de rayonnement présentant une forte directivité et une surface d'émission homogène et restant de technologie fiable et reproductible.

Plus précisément l'invention a pour objet un extracteur de photons comportant une membrane à base de cristal photonique présentant un plan défini par deux directions comprenant un ensemble de motifs disposés de manière à former une cavité optique, depuis laquelle peuvent être extraits des photons **caractérisé en ce que** la membrane comporte au moins une région à proximité de la cavité, ladite région comportant des motifs répartis selon une double périodicité ($a_1$, $2a_1$, $a_2$, $2a_2$) et selon au moins une direction.

Selon une variante de l'invention, la membrane présente une double périodicité selon les deux directions.

Selon une variante de l'invention, les doubles périodicités sont réalisées par des trous de diamètres différents.

Selon une variante de l'invention, la variation relative de diamètre est de quelques pourcents.

Selon une variante de l'invention le ratio entre les rayons des trous et la période est compris entre environ 0,15 et 0,4.

Selon une variante de l'invention, le diamètre moyen des trous est de l'ordre de 250 nanomètres, la période la plus petite étant de l'ordre de 200 nanomètres à 400 nanomètres pour des applications fonctionnant dans le domaine de 900nm à 1600nm.

Selon une variante de l'invention, la période de la structure relative à la longueur d'onde correspondant au domaine spectral concerné est de l'ordre de 0.25 à 0.35.

Selon une variante de l'invention, la membrane est réalisée dans un matériau semiconducteur de type GaAs ou InP.

Selon une variante de l'invention, la membrane est réalisée en un matériau électro-optique de type LiNbO3.

Selon une variante de l'invention la membrane est réalisée dans un matériau non-linéaire optiquement de type matériau ferroélectrique.

L'invention a aussi pour objet un dispositif optique comportant un extracteur de photons selon l'invention, ledit extracteur de photons étant couplé à un guide d'onde ou à une autre microstructure réalisée sur la membrane, de manière à injecter et extraire un signal optique dans ladite membrane.

L'invention sera mieux comprise et d'autres avantages apparaîtront à la lecture de la description qui va suivre donnée à titre non limitatif et grâce aux figures annexées parmi lesquelles :

- la figure 1 illustre l'intensité du champ électrique d'une onde électromagnétique se propageant dans ce type de structure et montre le diagramme de dispersion d'une structure de période a dans la première zone de Brillouin pour laquelle le vecteur d'onde k est compris dans l'intervalle $0 < k < \pi / a$ ;
- la figure 2 illustre une structure bidimensionnelle de cristal photonique comportant un guide d'onde ;
- la figure 3 illustre de manière qualitative la distribution angulaire du rayonnement à partir d'une cavité de cristal photonique selon l'art connu ;
- les figures 4a et 4b définissent le repère sphérique pour le rayonnement par rapport a l'orientation d'une cavité à cristal photonique et la cavité correspondante est représentée dans un repère cartésien ;
- la figure 5 illustre la répartition angulaire du rayonnement, typique de l'intensité normalisée en fonction de la coordonnée polaire θ pour une cavité telle que représentée en figure 4a ;
- la figure 6 représente le rayonnement dans le référenciel polaire de l'exemple de cavité illustrée en figure 4a ;
- les figures 7a et 7b illustrent la phase de la composante Ey du champ électrique pour des cavités L2 et L3 ;
- la figure 8 illustre la relation entre phase du champ électrique et modification des motifs pour une cavité L3;
- la figure 9 illustre le diagramme de rayonnement d'une cavité L5 dans laquelle ont été introduits des variations de motifs à proximité de la cavité ;
- la figure 10 illustre un exemple de cavité L5 optimisée pour extraction;
- la figure 11 illustre le diagramme de rayonnement de la cavité illustrée en figure 10. ;
- les figures 12a et 12b établissent la connexion entre les modes optiques se propageant dans la structure périodique représentée en figure 12b et le diagramme de dispersion représenté en figure 12a dans un exemple de structure à cristal photonique de l'invention ;
- les figures 13a et 13b illustrent un mode d'une cavité dans l'espace réciproque et la cavité correspondante dans un exemple de structure à cristal photonique de l'art antérieur ;
- les figures 14a et 14b illustrent un mode d'une cavité dans l'espace réciproque et la cavité modifiée correspondante dans un exemple de structure à cristal photonique de l'invention ;
- la figure 15 illustre un exemple de réalisation de structure périodique modifiée selon une seule direction conformément à l'invention;
- les figures 16a et 16b illustrent un premier exemple d'optimisation de cavité de type L5, la figure 16a étant relative à la cavité initiale et la figure 16b étant relative à celle utilisée dans un extracteur selon l'invention ;
- les figures 17a et 17b illustrent un second exemple d'optimisation de cavité de type L5, la figure 17a étant relative à la cavité initiale et la figure 17b étant relative à celle utilisée dans un extracteur selon l'invention.

De manière générale, l'extracteur de photons comporte une membrane à base de cristal photonique présentant une structuration périodique suivant deux directions dans son plan.

Plus précisément, on considère un maillage périodique triangulaire dont les axes principaux forment un angle pouvant par exemple être de 60 degrés.

Cette structure comprend une cavité obtenue en supprimant ou en modifiant localement un certain nombre des motifs, par exemple 3 motifs suivant une ligne ou des structures plus complexes comme décrit dans les articles de T. Asano et al., Ultrahigh-Q Nanocavities in Two-Dimensional Photonic Crystal Slabs, IEEE Journal Select. Topic in Quantum Electr., V. 12, n. 6, p. 1123 (2006), figures 1, 7, 13 et 17, et E. Kuramochi et al., Ultrahigh-Q photonic crystal nanocavities realized by the local width modulation of a line defect, Appl. Phys. Lett. V. 88, p. 041112 (2006), fig 1, et K.Nozaki and T. Baba, Laser characteristics with ultimate-small modal volume in photonic crystal slab point-shift nanolasers, Appl. Phys. Lett. V. 88, p. 211101 (2006), depuis laquelle peuvent être extraits des photons.

La structure utilisée dans un extracteur de l'invention est **caractérisée en ce que** la membrane comporte au moins une région à proximité de la cavité, ladite région comportant des motifs répartis avec une double périodicité selon au moins une direction.

Ainsi, selon la présente invention, il est proposé une technique d'optimisation et des exemples de structures ainsi optimisées qui présentent une bien meilleure tolérance en termes d'imperfections de fabrication tout en assurant le même niveau de couplage que la structure proposée de type « hexapole ».

La solution apportée repose sur le principe du repliement de bande encore dénommé « band-folding » dans une structure à cristaux photoniques et permettant de concentrer les directions d'émission de photons dans un cône présentant une directivité fortement accrue.

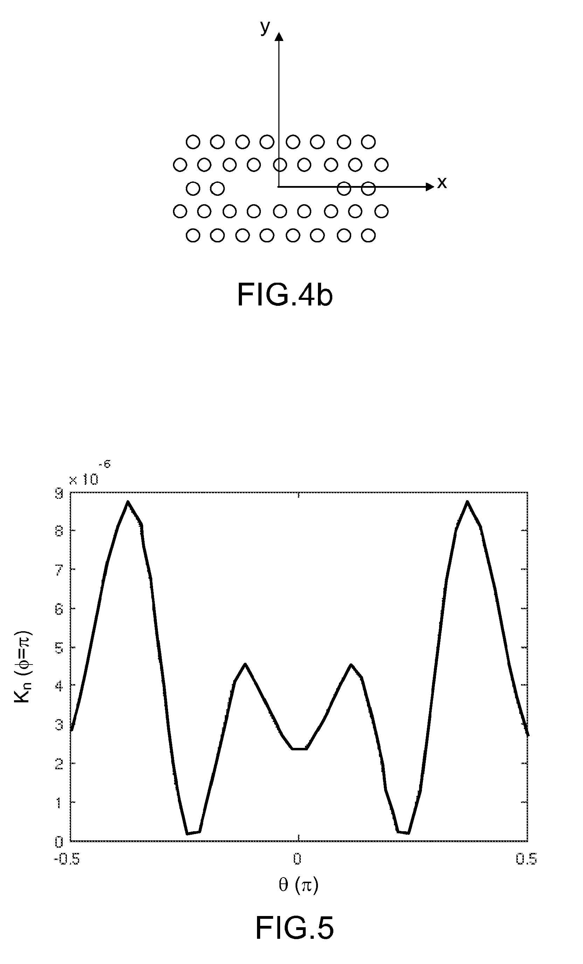

De manière générale, on peut représenter une cavité photonique dans un repère cartésien et dans un repère sphérique comme illustré respectivement en figure 4a et 4b qui sont relatives à un exemple de cavité dite L3 en raison de l'absence de 3 trous alignés. Pour valider le principe de l'invention, il convient de s'intéresser à la distribution du champ électrique $E_y$ suivant le plan de symétrie de la cavité. L'intensité de rayonnement correspondant à la puissance rayonnée par angle solide est une grandeur K dépendante des coordonnées $\theta$ et $\varphi$. Cette quantité en fonction de $\theta$ et $\varphi$ dans les coordonnées cylindriques représente comment la cavité rayonne et est liée au vecteur de Poynting $\vec{I}(\vec{r})$ par la relation :

$$K(\theta,\phi) = \lim_{|r|\to\infty} \frac{\vec{I}(\vec{r}).\hat{r}}{|r|^2}$$

On définit ici l'intensité normalisée de rayonnement :

$$\int K_n(\theta,\phi)\sin\theta d\theta d\phi = \frac{1}{Q} \quad ou \quad K_n(\theta,\phi) = \frac{K(\theta,\phi)}{W.\omega}$$

avec $W$ énergie du mode de la cavité, $\omega$ fréquence de résonance et Q le facteur de qualité de la cavité.

La figure 5 illustre ainsi un exemple d'évolution de l'intensité normalisée en fonction de la coordonnée polaire $\theta$ pour une cavité très simple à trois trous alignés telle que représentée en figure 4a.

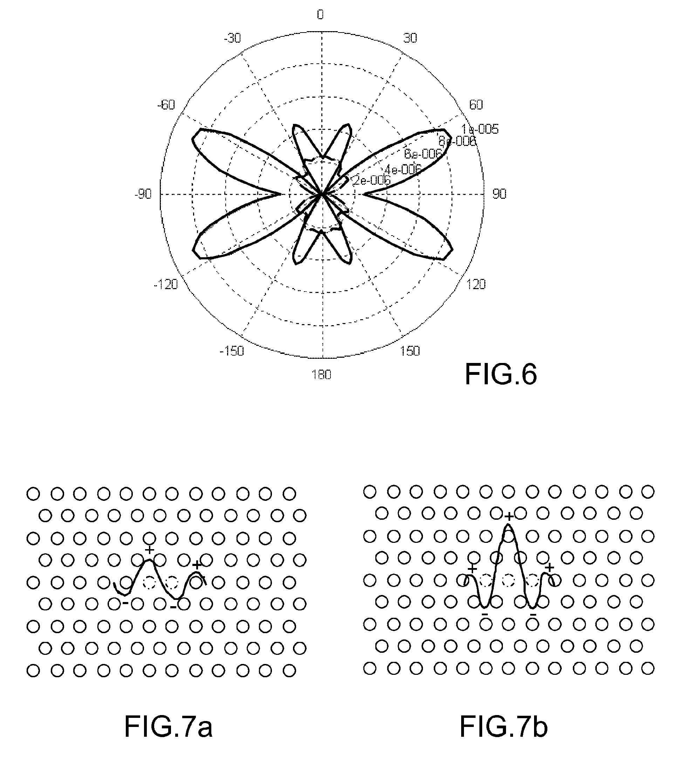

La figure 6 représente le diagramme de rayonnement dans le référenciel polaire. Cette figure montre que le rayonnement de cette cavité est faible dans la direction verticale (où $\theta$ = 0) devant d'autres directions.

Il est possible d'introduire une quantité pour apprécier le rayonnement vertical d'une cavité :

$$\eta_{coll}^{NA} = \frac{\int_{|\sin(\theta)|\leq NA} K_n \sin\theta d\theta d\phi}{\int K_n \sin\theta d\theta d\phi}$$

Cette valeur traduit quel pourcentage de l'énergie rayonnée se trouve dans une ouverture numérique NA par rapport à l'énergie rayonnée totale se traduisant par l'intensité normalisée de rayonnement : $\int K_n \sin\theta d\theta d\phi$

Il a ainsi été établi les valeurs suivantes :

$$\text{NA = 0,1 : } \eta_{coll}^{NA} = 0.29\%$$

$$\text{NA = 0,2 : } \eta_{coll}^{NA} = 1,21\ \%$$

$$\text{NA = 0,4 : } \eta_{coll}^{NA} = 9,01\ \%$$

$$\text{NA = 0,6 : } \eta_{coll}^{NA} = 22,69\ \%$$

Par l'amélioration du rayonnement vertical (c'est-à-dire l'obtention d'un faisceau rayonné plus étroit et contenant la plupart de l'énergie rayonnée) on peut montrer que la quantité $\eta_{coll}^{NA}$ est considérablement augmentée.

Afin de comprendre le lien entre champ proche et champ lointain, on peut considérer d'abord la limite de Fraunhofer. Dans ce cas, le vecteur de Poynting est proportionnel à $|E_{//}(k_{//})|^2 + \eta^2 |H_{//}(k_{//})|^2$. En particulier, la contribution à l'émission verticale est proportionnelle à la valeur en k=0, ce qui revient à une intégrale suivant le plan du champ proche.

On voit que la cavité de type L(2n), par exemple L2, possède une distribution du champ anti-symétrique par rapport à son centre géométrique.

Dès qu'on fait une intégrale spatiale pour calculer le champ lointain, les parties positives du champ sont compensées par celle négatives, il en résulte qu'à l'intérieur du cône de lumière, il reste très peu d'énergie comme cela est illustré en figure 7a et 7b. Cela veut dire que la cavité rayonne très faiblement.

Le comportement d'une cavité L(2n+1), par exemple L3, diffère de celui L(2n). La distribution du champ a une intensité très forte au centre de la cavité (trou central) et moins forte ailleurs (2 trous à côté). L'intégrale spatiale de cette distribution donne une composante résiduelle dans le cône de lumière en raison des parties négatives qui ne sont pas assez grandes pour pouvoir compenser celles positives. Ce type de cavité a capacité de présenter un bon rayonnement.

Il apparait ainsi donc en premier lieu qu'une cavité L(2n+1) peut rayonner mieux qu'une cavité L(2n).

L'idée d'optimisation proposée à partir de ce concept repose sur le fait de forcer la différence entre les parties positives et négatives dans la distribution du champ. Plus cette différence est importante, plus le rayonnement vertical est fort.

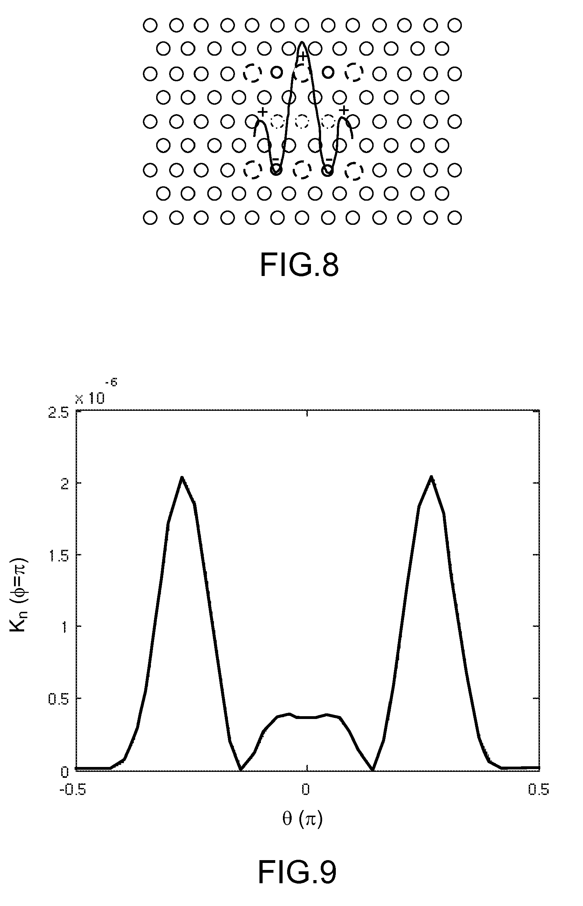

Pour forcer la différence en question, on peut opérer une petite modulation au niveau du rayon des trous se trouvant sur les deuxièmes rangées comptées à partir du centre de cavité comme représenté en figure 8. La modulation permet de diminuer la partie négative, augmenter la partie positive et par conséquent obtenir un rayonnement vertical plus fort.

Des mesures similaires ont été réalisées pour une cavité dite L5 à cinq motifs centraux absents. Le diagramme de rayonnement correspondant est illustré en figure 9.

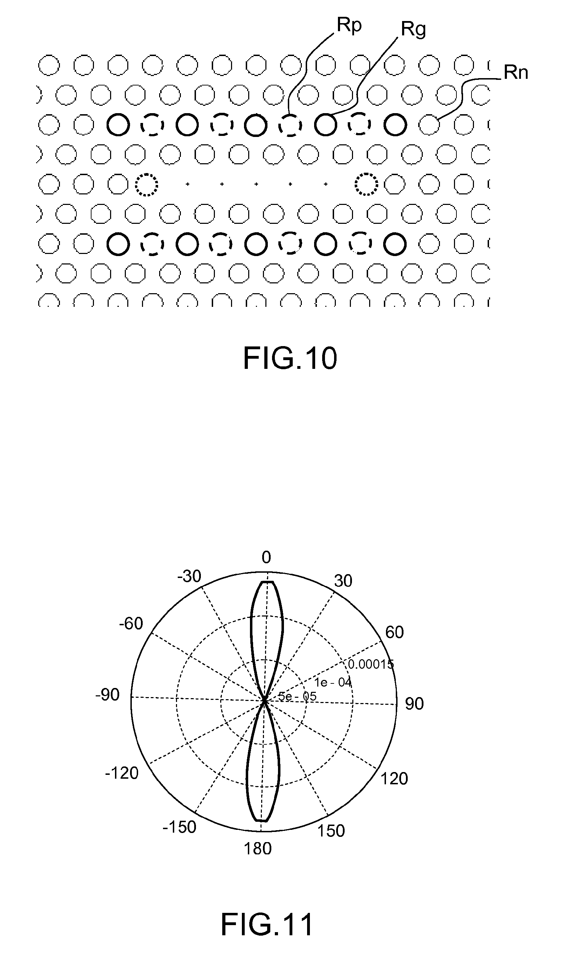

Selon l'invention, cette cavité est optimisée en élargissant et en réduisant la taille des trous des deuxièmes rangées comptées depuis le centre de la cavité de manière à créer localement une double période. Un triple de rayons : (Rp - Rn - Rg) présente le rayon des petits trous, des trous normaux et des grands trous comme illustré par la cavité représentée en figure 10 dont le diagramme de rayonnement est illustré en figure 11.

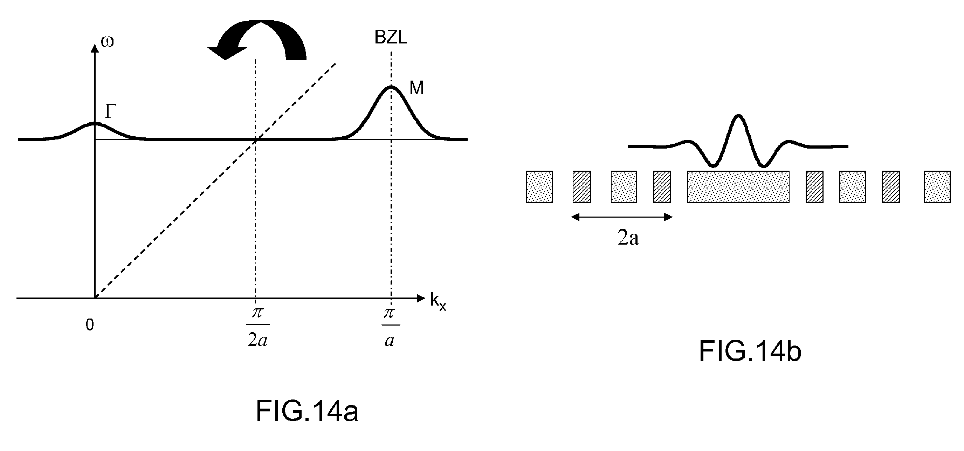

A partir de ces analyses menées de proche en proche, la demanderesse a montré qu'une approche systématique conduisant au repliement de bandes était extrêmement prometteuse pour concentrer le maximum d'énergie dans un cône de directivité très resserré comme illustré sur les schémas des figures 14a et 14b.

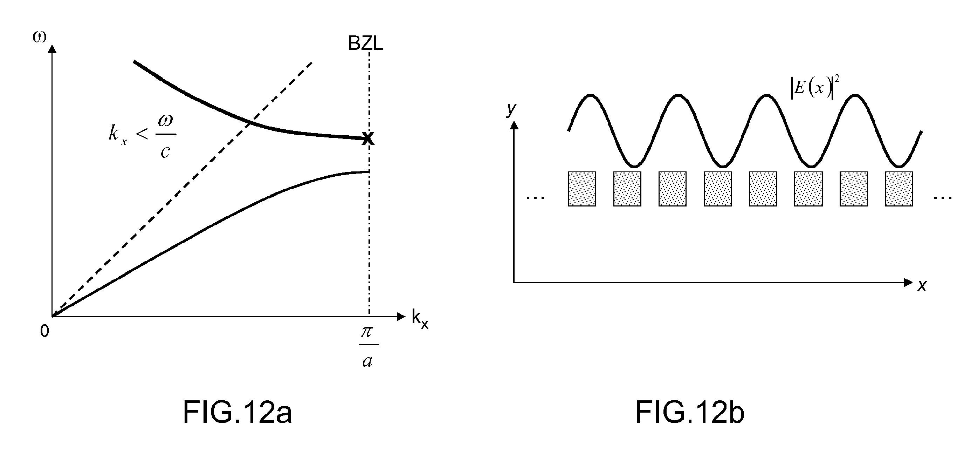

On définit d'abord la procédure pour les structures périodiques selon une seule direction. Les figures 12a et 12b établissent la connexion entre les modes optiques se propageant dans la structure périodique représentée en figure 12b et le diagramme de dispersion représenté en figure 12a qui est représenté dans l'espace réciproque. Si a est la période de la structure, les modes optiques sont représentés par un continuum de points associant une valeur de la fréquence du mode à son vecteur de propagation k, qui est compris entre $-\pi/a$ et $\pi/a$. Les modes se propageant dans les deux directions étant identiques, le diagramme est symétrique, donc seule une représentation sur l'intervalle de 0 à $\pi/a$ suffit. Chaque mode correspond à un point de la courbe représentée en figure 12a. Par exemple le mode illustré en figure 12b est représenté par le point 'x' en figure 12a.

En ce qui concerne les structures membranaires (domaine de l'invention), l'espace réciproque se divise en deux espaces. Celui dans lequel $k_x < \omega/c$ correspond à des modes qui rayonnent hors du plan de la structure. Ces modes ne sont pas adaptés pour la propagation. En revanche, les modes tels que $k_x > \omega/c$ sont bien confinés dans la structure.

L'angle du rayonnement $\theta$ par rapport à la perpendiculaire à la structure est donné par la relation: $\sin(\theta) = k_x c / \omega$. Par exemple, si $k_x = 0$, le rayonnement est émis à la verticale. Le mode représenté par le point 'x' en figure 12a ne rayonne pas.

En contraste avec un mode d'une structure périodique, le mode d'une cavité a une extension spatiale finie.

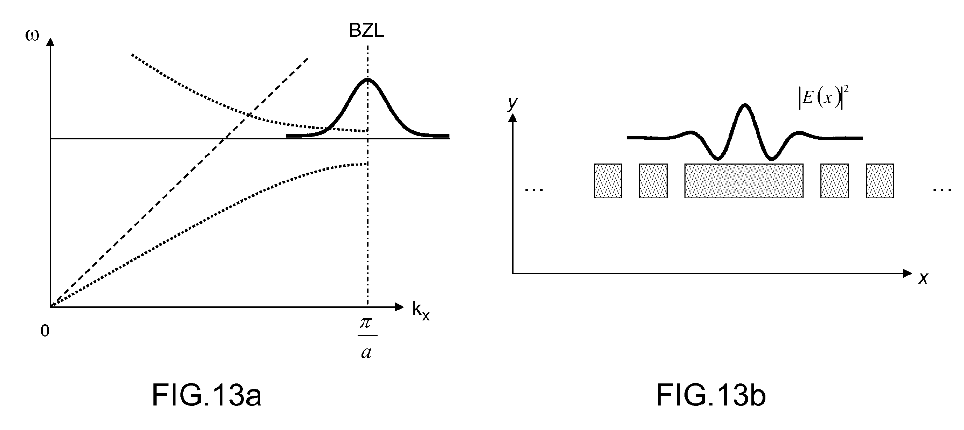

On peut obtenir une cavité à partir d'une structure périodique, en introduisant une perturbation de la périodicité, par exemple, par omission d'un motif comme représenté en figure 13b.

La représentation du mode d'une cavité dans l'espace réciproque consiste en une distribution qui est centrée sur le point de l'espace réciproque correspondant au mode de la structure non perturbée initiale comme représenté en figure 13a.

La distribution du champ dans l'espace réciproque est telle qu'une partie de champ se trouve aussi dans la région $k_x < \omega/c$. Cela implique que toute cavité fabriquée sur des membranes rayonne, ce qui établit une limite intrinsèque à leur facteur de qualité (la capacité à retenir l'énergie).

Toutefois, ces effets peuvent être réduits à des niveaux négligeables par l'optimisation du dessin de la structure. C'est ainsi qu'il est actuellement possible d'obtenir des facteurs de qualité de l'ordre du million avec cette technologie comme décrit notamment dans la littérature : T. Asano et al., Ultrahigh-Q Nanocavities in Two-Dimensional Photonic Crystal Slabs, IEEE Journal Select. Topic in Quantum Electr., V. 12, n. 6, p. 1123 (2006); E. Kuramochi et al., Ultrahigh-Q photonic crystal nanocavities realized by the local width modulation of a line defect, Appl. Phys. Lett. V. 88, p. 041112 (2006); K.Nozaki and T. Baba, Laser characteristics with ultimate-small modal volume in photonic crystal slab point-shift nanolasers, Appl. Phys. Lett. V. 88, p. 211101 (2006);

Les procédés d'optimisation du facteur de qualité ne tiennent pas compte, en général, de la distribution angulaire du rayonnement résiduel. Celui ci dépend de la distribution du champ dans la région $k_x < \omega/c$ de l'espace réciproque. Il s'ensuit que le diagramme angulaire du rayonnement est très irrégulier comme illustré en figure 6.

Le principe qui est utilisé dans la présente invention consiste en un repliement dans l'espace réciproque tel que le pic de la distribution est reproduit avec un facteur d'échelle au point $k_x = 0$ (voir figure 13a). Il s'ensuit que le rayonnement se fait à l'angle $\theta = 0$ avec une distribution angulaire régulière, proche de celle (optimale) d'un mode gaussien.

Un cas particulier très important est celui dans lequel le pic principal se trouve au bord de la zone de Brillouin (BZL). Ceci est le cas représenté en figure 13a. Dans ce cas, il suffit de modifier la structure de manière à introduire une période 2a comme représenté en figure 14b, par exemple, en modifiant la taille des motifs. L'entité de cette perturbation fixe le facteur d'échelle entre le pic principal (M) et le pic secondaire ($\Gamma$). Cela est lié à l'intensité du couplage de la cavité avec le mode d'émission.

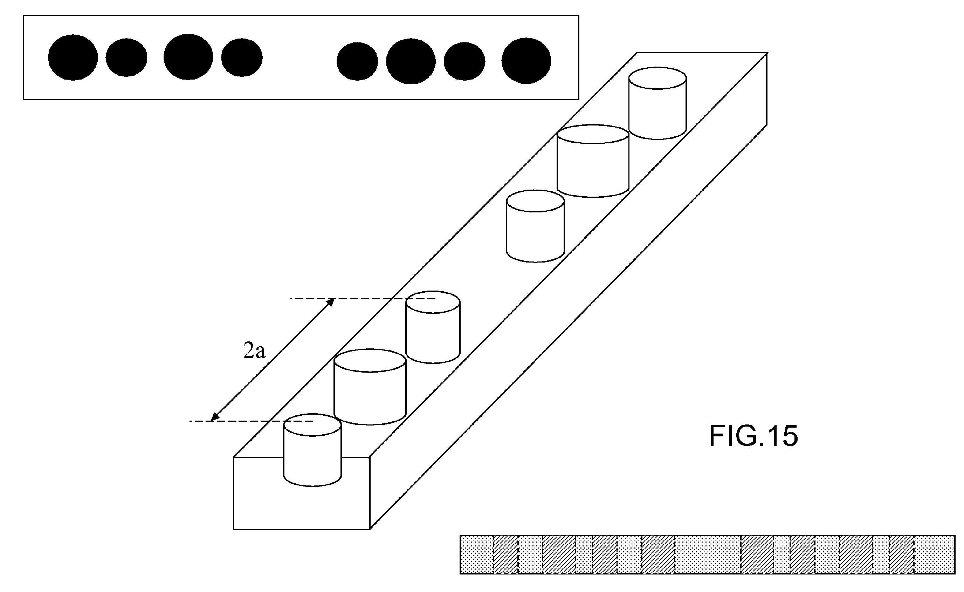

La figure 15 illustre une réalisation possible de structures périodiques selon une seule direction.

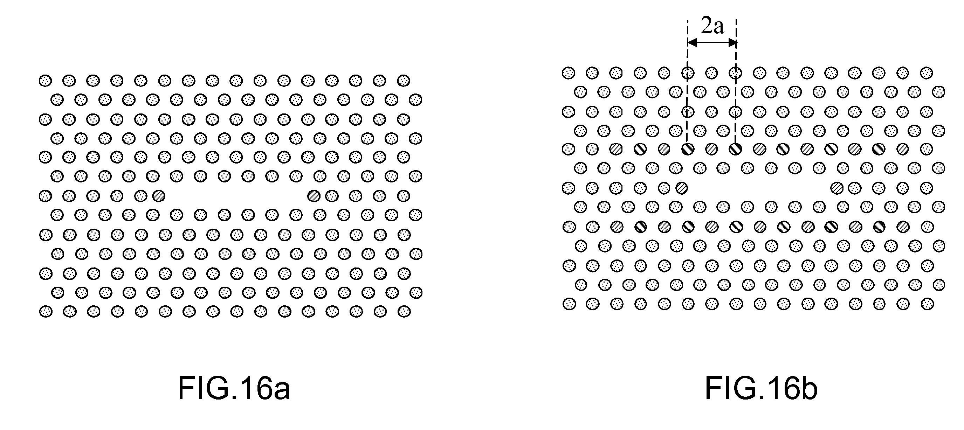

L'extension du principe au cas des structures à deux dimensions est plus compliquée, mais le principe est le même. Les figures 16a et 16b illustrent comment on optimise une cavité de type L5 (figure 16a) en un extracteur (figure 16b), dont le diagramme de rayonnement est décrit en figure 11.

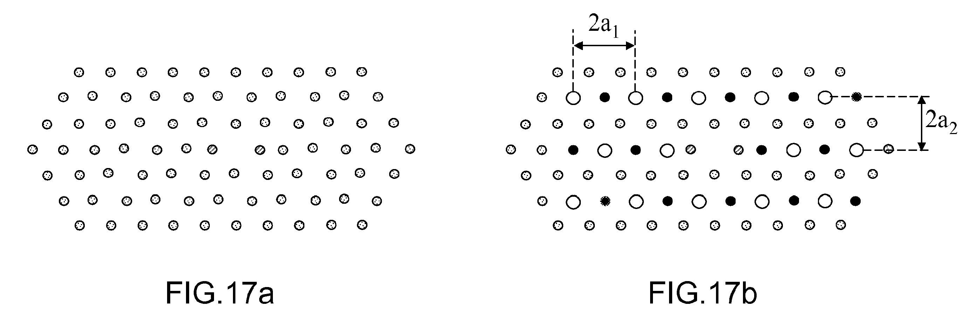

Un autre type de cavité qu'on a optimisé par le même procédé est celle décrite dans l'article K.Nozaki and T. Baba, Laser characteristics with ultimate-small modal volume in photonic crystal slab point-shift nanolasers, Appl. Phys. Lett. V. 88, p. 211101 (2006). Cela est montré en figures 17a (cavité originelle) et 17b (extracteur) avec la double périodicité $a_1$ et $a_2$.

Exemple de réalisation et validation du principe de l'invention :

L'extracteur de l'invention peut être constitué d'une membrane en matériau semiconducteur de type silicium ou de type matériau III-V pouvant notamment être du GaAs, du GaAlAs, du GaInP,....

L'épaisseur de la membrane peut être de l'ordre de quelques centaines de nanomètres.

La périodicité des motifs peut être de l'ordre de quelques centaines de nanomètres, typiquement 400 nanomètres.

Le diamètre des motifs pouvant typiquement être des trous peut être de l'ordre de 250 nanomètres. On choisit ainsi un ratio typiquement de l'ordre de 0,15 à 0,35 entre le diamètre des motifs et la période desdits motifs.

Selon l'invention, la membrane comporte une zone dans laquelle des motifs sont absents de manière à créer la cavité depuis laquelle on extrait les photons, typiquement il peut s'agir de quelques unités de motifs.

Dans une région voisine de la cavité, on créé une double périodicité avec des motifs de diamètres différents. Tous les motifs séparés d'une période 2a sont par exemple des trous plus petits et des trous plus grands.

L'invention ci-décrite permet d'atteindre un taux de collection de l'ordre de 80%, qui est suffisant pour les applications les plus exigeantes (source de photons pour le calcul quantique par exemple).

**Revendications**

1. Extracteur de photons comportant une membrane à base de cristal photonique présentant un plan défini par deux directions comprenant un ensemble de motifs disposés de manière à former une cavité optique, depuis laquelle peuvent être extraits des photons **caractérisé en ce que** la membrane comporte au moins une région à proximité de la cavité, ladite région comportant des motifs répartis selon une double périodicité ($a_1$, $2a_1$, $a_2$, $2a_2$) et selon au

moins une direction, permettant un diagramme de rayonnement présentant une forte directivité et une surface d'émission homogène.

**2.** Extracteur de photons selon la revendication 1, **caractérisé en ce que** la membrane comporte des motifs périodiques selon les deux directions orthogonales entre elles.

**3.** Extracteur de photons selon l'une des revendications 1 ou 2, **caractérisé en ce que** les doubles périodicités sont réalisées par des trous de diamètres différents.

**4.** Extracteur de photons selon la revendication 3, **caractérisé en ce que** la variation relative de diamètre est de quelques pourcents.

**5.** Extracteur de photons selon l'une des revendications 1 ou 2, **caractérisé en ce que** les doubles périodicités sont réalisées par un déplacement des trous.

**6.** Extracteur de photons selon la revendication 5, **caractérisé en ce** le déplacement relatif est de quelques pourcents.

**7.** Extracteur de photons selon l'une des revendications 1 à 6, **caractérisé en ce que** le ratio entre les rayons des trous et la période est compris entre environ 0,15 et 0,4.

**8.** Extracteur de photons selon l'une des revendications 1 à 7, **caractérisé en ce que** le diamètre moyen des trous est de l'ordre de 250 nanomètres, la période la plus petite étant de l'ordre de 400 nanomètres de manière à émettre des photons dans une bande spectrale de l'ordre de 1300nm à1600 nm, pour des applications de télécommunications.

**9.** Extracteur de photons selon l'une des revendications 1 à 7, **caractérisé en ce que** la période de la structure relative à la longueur d'onde correspondant au domaine spectral concerné est de l'ordre de 0.25 à 0.35.

**10.** Extracteur de photons selon l'une des revendications 1 à 7, **caractérisé en ce que** la membrane est réalisée dans un matériau semiconducteur de type silicium.

**11.** Extracteur de photons selon l'une des revendications 1 à 7, **caractérisé en ce que** la membrane est réalisée dans un matériau III-V de type GaAs, GaAlAs, INP, GaInP.

**12.** Extracteur de photons selon l'une des revendications 1 à 7, **caractérisé en ce que** la membrane est réalisée dans un matériau électro-optique de type LiNb03.

**13.** Extracteur de photons selon l'une des revendications 1 à 7, **caractérisé en ce que** la membrane est réalisée dans un matériau non-linéaire optiquement de type matériau ferroélectrique.

**14.** Dispositif optique comportant un extracteur de photons selon l'une des revendications 1 à 13, ledit extracteur de photons étant couplé à un guide d'onde ou à une autre microstructure réalisée sur la membrane, de manière à injecter et extraire un signal optique dans ladite membrane.

FIG.1

FIG.2

émetteur

t

FIG.3

FIG.4a

FIG.4b

FIG.5

FIG.6

FIG.7a

FIG.7b

FIG.8

FIG.9

FIG.10

FIG.11

FIG.12b

FIG.12a

EP 2 144 099 A1

FIG.13a

FIG.13b

FIG.14a

FIG.14b

EP 2 144 099 A1

FIG.15

FIG.16b

FIG.16a

FIG.17b

FIG.17a

Europäisches
Patentamt

European
Patent Office

Office européen
des brevets

## RAPPORT DE RECHERCHE EUROPEENNE

Numéro de la demande

EP 09 16 4818

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 6 711 200 B1 (SCHERER AXEL [US] ET AL) 23 mars 2004 (2004-03-23) <br> * abrégé * <br> * colonne 5, ligne 30 - colonne 6, ligne 8 * <br> ----- | 1-14 | INV. <br> G02B6/122 <br> H01S5/18 |
| X | US 2008/159679 A1 (SIGALAS MIHAIL [US] ET AL) 3 juillet 2008 (2008-07-03) <br> * abrégé * <br> * alinéa [0058]; figure 12 * <br> ----- | 1-14 | |
| A | BRISTOW A D ET AL:  "Defect states and commensurability in dual-period AlxGa1-xAs photonic crystal waveguides" PHYSICAL REVIEW B (CONDENSED MATTER AND MATERIALS PHYSICS) APS THROUGH AIP USA, vol. 68, no. 3, 15 juillet 2003 (2003-07-15), pages 33303-1, XP002515791 ISSN: 0163-1829 <br> * le document en entier * <br> ----- | 1-14 | |
| A | FRANCARDI M ET AL:  "Quantum dot photonic crystal nanocavities at 1300 nm for telecom-wavelength single-photon sources" PHYSICA STATUS SOLIDI C WILEY-VCH GERMANY, no. 11, 2006, pages 3693-3696, XP002515792 ISSN: 1610-1634 <br> * le document en entier * <br> ----- | 5 | **DOMAINES TECHNIQUES RECHERCHES (IPC)** <br><br> G02B <br> H01S |

Le présent rapport a été établi pour toutes les revendications

| Lieu de la recherche | Date d'achèvement de la recherche | Examinateur |
|---|---|---|
| La Haye | 23 septembre 2009 | Cohen, Adam |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

 

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 09 16 4818

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-09-2009

| Document brevet cité au rapport de recherche | Date de publication | Membre(s) de la famille de brevet(s) | Date de publication |
|---|---|---|---|
| US 6711200 B1 | 23-03-2004 | AUCUN | |
| US 2008159679 A1 | 03-07-2008 | WO 2008085819 A1 | 17-07-2008 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Se-Heon Kim ; Sun-Kyung Kim ; Yong-Hee Lee.** Vertical beaming of wavelength-scale photonic crystal resonators. *PHYSICAL REVIEW B,* 2006, vol. 73, 235117
- **T. Asano et al.** Ultrahigh-Q Nanocavities in Two-Dimensional Photonic Crystal Slabs. *IEEE Journal Select. Topic in Quantum Electr.,* 2006, vol. 12 (6), 1123

- **E. Kuramochi et al.** Ultrahigh-Q photonic crystal nanocavities realized by the local width modulation of a line defect. *Appl. Phys. Lett.,* 2006, vol. 88, 041112
- **K.Nozaki ; T. Baba.** Laser characteristics with ultimate-small modal volume in photonic crystal slab point-shift nanolasers. *Appl. Phys. Lett.,* 2006, vol. 88, 211101